# EUROPÄISCHE PATENTANMELDUNG

(11) **EP 2 461 167 A1**
(43) Veröffentlichungstag der Anmeldung: **06.06.2012**
(21) Anmeldenummer: 11008457.1
(22) Anmeldetag: 21.10.2011
(51) Int. Cl.: G01R 11/04

(54) **Zählertraggehäuse für einen Zählerschrank**

(30) Priorität: 01.12.2010 DE 202010016085 U
(71) Anmelder: ABB AG, 68309 Mannheim (DE)
(72) Erfinder: Wieland, Ralf, 69429 Waldbrunn (DE); Eppe, Klaus-Peter, 69429 Waldbrunn (DE); Siedelhofer, Bernd, 69121 Heidelberg (DE)

(57) **Zusammenfassung**

Die Erfindung betrifft ein Zählertraggehäuse (17) für einen Zählerschrank zur Montage eines Zählers, mit wenigstens drei Einführöffnungen (34, 35, 36, 36') für die Aufnahme von Anschlussleitern (37, 37'), und mit wenigstens drei Ausgangsöffnungen für die Aufnahme von Abgangsleitern (38). Diejenigen Einführöffnungen (34, 36), die nicht zur Aufnahme eines Anschlussleiters vorgesehen sind, sind mit einem Einführ-Abdeckteil (39, 39') versehen, und diejenigen Ausgangsöffnungen, die nicht zur Aufnahme eines Abgangsleiters vorgesehen sind, sind mit einem Abgangs-Abdeckteil versehen.

## Beschreibung

Die Erfindung betrifft ein Zählertraggehäuse für einen Zählerschrank zur Montage eines Zählers, mit wenigstens drei Einführöffnungen für die Aufnahme von Anschlussleitern, und mit wenigstens drei Ausgangsöffnungen für die Aufnahme von Abgangsleitern.

Ein solches Zählertraggehäuse ist beispielsweise aus der DE 10 2004 022 783 B4 oder aus der DE 10 2004 022 785 A1 bekannt.

Ein Stromzähler, beispielsweise ein elektronischer Haushaltszähler, der mit Kontaktfahnen an seiner Unterseite versehen ist, kann zur Montage auf das Zählertraggehäuse aufgesetzt werden, wobei innerhalb des Zählertraggehäuses Kontaktstücke vorgesehen sind, mit denen die Kontaktfahnen in elektrisch leitende Verbindung bringbar sind. Die Kontaktstücke sind dabei üblicherweise U-förmig ausgebildet und über an einem der Schenkel der U-Form angeschlossene Anschlussfahnen mit Zu- bzw. Abgangsleitern verbunden.

Das Zählertraggehäuse hat eine im wesentlichen quaderförmige Gestalt. In seiner oberen Breitseite sind Schlitze zur Aufnahme der Kontaktfahnen des Stromzählers vorhanden.

Ein solches Zählertraggehäuse wird auch als Befestigungs- und Kontaktiereinrichtung, abgekürzt BKE, für einen Stromzähler bezeichnet. Wenn der BKE in dem Zählerschrank der Installationsanlage fest eingebaut ist, bildet der BKE einen Teil des Zählerplatzes, er ist gewissermaßen in den Zählerplatz integriert und wird dann auch kurz als BKE-1 bezeichnet. Ein BKE-1 hat an einer ersten Schmalseite des Gehäuses, die hier daher auch als Einführ-Schmalseite bezeichnet wird, Einführöffnungen für die Aufnahme von Zugangsleitern bei der Installation in dem Zählerschrank, auch als Anschlussleiter bezeichnet. An einer zweiten Schmalseite, die hier daher auch als Abgangs-Schmalseite bezeichnet wird, und die der Einführ-Schmalseite üblicherweise gegenüberliegt, hat ein BKE-I Ausgangsöffnungen für die Aufnahme von Abgangsleitern bei der Installation in dem Zählerschrank. Der Stromzähler ist also mittels eines BKE-1 im Zählerschrank elektrisch zwischen den Zugangs- und den Abgangsleitern geschaltet.

Bekannt sind bisher BKE-1 Zählertraggehäuse für dreiphasige Anwendungen. Sie haben daher mindestens drei Einführöffnungen für die Aufnahme der drei Phasenleiter L1, L2, L3, und oft noch eine weitere Einführöffnung für die Aufnahme eines Neutralleiters N. Der Neutralleiter N dient zur Versorgung des elektronischen Stromzählers. Weiter haben bekannte BKE-I Zählertraggehäuse mindestens drei Ausgangsöffnungen für die Aufnahme der drei abgehenden Phasenleiter L1, L2, L3. Es kann auch hier eine weitere Ausgangsöffnung für die Aufnahme eines abgangsseitigen Neutralleiters vorhanden sein.

Im Zuge der weiteren Entwicklung sollen auch BKE-1 Zählertraggehäuse für einphasige Zähleranwendungen, welche lediglich eine Zugangsöffnung für einen Phasenleiter sowie ggf. eine weitere Zugangsöffnung für einen Neutralleiter und lediglich eine Ausgangsöffnung für einen Abgangsleiter haben, realisiert werden.

Es ist daher die Aufgabe der vorliegenden Erfindung, ein Zählertraggehäuse für einphasige Anwendungen zu schaffen, das einfach und kostengünstig zu realisieren ist.

Die Aufgabe wird gelöst durch ein Zählertraggehäuse mit den kennzeichnenden Merkmalen des Anspruchs 1.

Erfindungsgemäß also sind diejenigen Einführöffnungen, die nicht zur Aufnahme eines Anschlussleiters vorgesehen sind, mit einem Einführ-Abdeckteil versehen, und diejenigen Ausgangsöffnungen, die nicht zur Aufnahme eines Abgangsleiters vorgesehen sind, sind mit einem Abgangs-Abdeckteil versehen..

Der Vorteil eines erfindungsgemäß gestalteten Zählertraggehäuses liegt darin, dass im Wesentlichen das bekannte Zählertraggehäuse für die bekannte dreiphasige Anwendung auch für die einphasige Anwendung verwendet werden kann. Durch das erfindungsgemäß vorgesehene Zugangs- und Abgangs-Abdeckteil wird bei der Installation des Zählertraggehäuses in dem Zählerschrank ein Fehlstecken des jeweils einen Phasenleiters zugangs- und abgangsseitig verhindert. Ansonsten brauchen am dreiphasigen Zählertraggehäuse keinerlei Änderungen vorgenommen zu werden, um von der dreiphasigen zu der einphasigen Verwendung zu wechseln. Damit ist eine sehr kostengünstige Lösung für die Realisierung eines einphasigen Zählertraggehäuses geschaffen.

In einer vorteilhaften Ausführungsform der Erfindung sind nur denjenigen Ein- und Ausgangsöffnungen, die zur Aufnahme eines Anschluss- bzw. Abgangsleiters vorgesehen sind, entsprechende Kontaktstücke im Inneren des Zählertraggehäuses zugeordnet. Bei dem einphasigen Zählertraggehäuse sind also, ausgehend von dem dreiphasigen Zählertraggehäuse, die den beiden nicht vorhandenen Phasenanschlüssen zugeordneten Kontaktstücke im Inneren des Zählertraggehäuses entfernt worden. Das einphasige Zählertraggehäuse entsprechend der vorliegenden Erfindung hat somit auch nur für die eine anzuschließende Phase entsprechende Kontaktstücke im Inneren des Zählertraggehäuses vorgesehen. Damit werden trotz der Verwendung eines im Vergleich zu der dreiphasigen Verwendung kaum veränderten Zählertraggehäuses bei einer einphasigen Ausführungsform erhebliche Material- und Montagekosten gespart.

Gemäß einer vorteilhaften Ausführungsform der Erfindung, bei der das Zählertraggehäuse ein Gehäuseunterteil und ein daran befestigbares Gehäuseoberteil umfasst, ist das Gehäuseoberteil mit dem Einführ-Abdeckteil und mit dem Abgangs-Abdeckteil versehen. Die Bildung eines Zählertraggehäuses aus einem Ober- und einem Unterteil, die bei der Montage schalenartig aufeinandergesetzt und miteinander verbunden werden, hat sich im Hinblick auf eine einfache Bestückbarkeit und hohe Montagefreundlichkeit bewährt. Die Kontaktstücke werden bei der Montage in das Gehäuseunterteil eingesetzt, das Gehäuseoberteil schließt das Gehäuse und stellt die Montagefläche für die Aufnahme und Halterung des Stromzählers zur Verfügung, einschließlich der Aufnahmeschlitze für die Kontaktfahnen des Stromzählers. Wenn der Stromzähler, wie im Stand der Technik bekannt und beschrieben, auch noch Haltekrallen zur mechanischen Halterung an dem Zählertraggehäuse hat, so werden auch diese an dem Gehäuseoberteil gehalten. In der Ausführungsform, bei der das Gehäuseoberteil mit dem Einführ-Abdeckteil und mit dem Abgangs-Abdeckteil versehen ist, sind Änderungen, die etwa für die Halterung des Abdeckteils notwendig werden könnten, nur an einer der beiden Gehäuseschalen vorzunehmen. Das Gehäuseunterteil kann vollkommen unverändert sowohl für die dreiphasige als auch für die einphasige Variante verwendet werden.

Gemäß einer vorteilhaften Ausführungsform der Erfindung sind das Einführ-Abdeckteil und das Abgangs-Abdeckteil an dem Gehäuseoberteil befestigt. Dadurch ist ein verlieren der Abdeckteile bei der Installation vermieden.

Gemäß einer vorteilhaften Ausführungsform der Erfindung sind das Einführ-Abdeckteil und das Abgangs-Abdeckteil an dem Gehäuseoberteil angeformt.

Ein Befestigen durch Anformen kann dadurch erreicht werden, dass die Deckel bei der Herstellung des Gehäuseoberteiles, beispielsweise bei Gehäuseteilen, die im Spritzgussverfahren hergestellt werden, daran mit angespritzt werden. Damit sind die Abdeckteile dann unverlierbar mit dem Zählertraggehäuse verbunden.

Gemäß einer vorteilhaften Ausführungsform der Erfindung sind das Einführ-Abdeckteil und das Abgangs-Abdeckteil separate Deckel, die an dem Gehäuseoberteil angebracht sind. Damit kann in vorteilhafter Weise auch das Gehäuseoberteil bei der einphasigen Variante unverändert gegenüber der dreiphasigen Variante übernommen werden. Der Deckel wird mit entsprechenden Haltevorrichtungen, die deckelseitig installiert sein können, in die nicht benötigten Einführ- bzw. Ausgangsöffnungen eingesetzt.

Gemäß einer vorteilhaften Ausführungsform der Erfindung sind das Einführ-Abdeckteil und das Abgangs-Abdeckteil an dem Gehäuseoberteil angerastet. Das Einführ-Abdeckteil und das Abgangs-Abdeckteil tragen hierzu beispielsweise Rasthaken, die in die nicht benötigten Einführ- bzw. Ausgangsöffnungen eingreifen und dort mit der Gehäusewand verrasten. Am Gehäuse selbst ist hierfür keine Änderung erforderlich,

Gemäß einer vorteilhaften Ausführungsform der Erfindung sind anstelle des Gehäuseoberteils das Gehäuseunterteil mit dem Einführ-Abdeckteil und mit dem Abgangs-Abdeckteil versehen. Diese Variante ist vorteilhafterweise dann anzuwenden, wenn die Einführ- bzw. Ausgangsöffnungen in dem Gehäuseunterteil festgelegt sind, beispielsweise durch entsprechende Stege in den Schmalseiten, zwischen denen dann die entsprechenden Einführ- bzw. Ausgangsöffnungen gebildet sind.

Gemäß einer vorteilhaften Ausführungsform der Erfindung sind Einführöffnungen für die Aufnahme von drei Phasenleitern und eines Neutralleiters vorhanden, und genau zwei der je einem Phasenleiter zugeordneten Einführöffnungen sind mit einem Einführ-Abdeckteil bedeckt, so dass zugangsseitig nur ein Phasenleiter und der Neutralleiter angeschlossen werden können.

Gemäß einer vorteilhaften Ausführungsform der Erfindung sind Ausgangsöffnungen für die Aufnahme von drei Phasenleitern vorhanden sind, und genau zwei der je einem Phasenleiter zugeordneten Ausgangsöffnungen sind mit einem Abgangs-Abdeckteil bedeckt, so dass abgangsseitig nur ein Phasenleiter angeschlossen werden kann.

Wenn bei der Beschreibung der Erfindung von einem Abdeckteil gesprochen wird, so kann das bedeuten, dass jede der zu bedeckenden Öffnungen mit einem eigenen Abdeckteil bedeckt ist. Es kann aber auch die Variante damit umfasst sein, gemäß der ein einziges Abdeckteil so gestaltet und an der Schmalseite des Gehäuses angebracht ist, dass es die beiden zu bedeckenden Öffnungen bedeckt, aber diejenige Öffnung, die für einen Anschlussleiter zugänglich bleiben soll, frei lässt.

Weitere vorteilhafte Ausgestaltungen und Verbesserungen der Erfindung und weitere Vorteile sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:

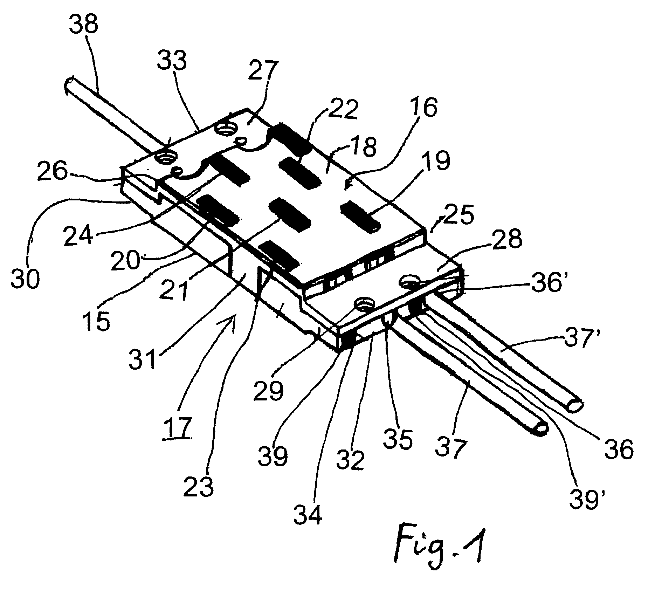

- Figur 1: ein erfindungsgemäßes Zählertraggehäuse mit einem zugangsseitig angeschlossenen Phasenleiter, einem zugangsseitig angeschlossenen Neutralleiter und einem abgangsseitig angeschlossenen Phasenleiter.
In den Figuren sind gleiche oder gleichwirkende Bauelemente oder Baugruppen mit denselben Bezugsziffern bezeichnet.

Die Figur 1 zeigt ein erfindungsgemäßes Zählertraggehäuse 17 mit einem zugangsseitig angeschlossenen Phasenleiter 37, der in Anlehnung an genormte Bezeichnungen für Phasenleiter als Phasenleiter L2 bezeichnet wird, einem zugangsseitig angeschlossenen Neutralleiter N, der die Bezugsziffer 37' trägt und einem abgangsseitig angeschlossenen Phasenleiter L2, der die Bezugsziffer 38 trägt.

Das Gehäuse 17 besitzt ein Gehäuseunterteil 15 sowie ein Gehäuseoberteil 16, die miteinander in nicht näher dargestellter Weise durch Verrastung und/oder Verschraubung verbunden sind. Innerhalb des Gehäuses befinden sich Kontaktstücke, die mit Kontaktfahnen am Zähler in elektrisch leitende Verbindung gelangen können; der Aufbau und die Anordnung der Kontaktstücke ist der DE 101 04 170 A1 zu entnehmen. Insoweit ist der Inhalt dieser Patentanmeldung hier von Bedeutung. Das Gehäuse 17 besitzt drei Abschnitte. In einem mittleren Abschnitt 18, auch Schlitzbereich 18 genannt, befinden sich Schlitze 19, 20, 21, 22, 23 und 24, durch die Kontaktfahnen am Zähler eingesteckt werden können. Schlitze, in die Haltekrallen eines Stromzählers eingreifen können, sind in der Ausführung gemäß Fig. 1 nicht dargestellt, können aber vorhanden sein.

Der Schlitzbereich 18 ist senkrecht zur Verbindungslinie zweier zugehöriger Schlitze durch eine Stufe 25 bzw. 26 begrenzt, über die der Schlitzbereich 18 in je einen abgangsseitigen bzw. zugangsseitigen Anschlussklemmenabschnitt 27 und 28 übergeht. Zu diesem Zweck besitzt auch das Gehäuseunterteil je eine Stufung 29, 30; ebenso sind am Gehäuseoberteil 16 Stufungen (ohne Bezugsziffern) vorgesehen, die den Stufungen 29, 30 entsprechen, so dass das Gehäuseoberteil 16 passend auf das Gehäuseunterteil 15 aufgesetzt werden kann. Am Gehäuseoberteil 16 ist eine Art Rastarm 31 auf den Seiten angeformt, die parallel zu der Verbindungslinie zugehöriger Schlitze verlaufen, so dass das Gehäuseoberteil mit dem Arm 31 am Gehäuseunterteil fixiert ist. Selbstverständlich können auch andere Arten der Verbindung zwischen Gehäuseunterteil 15 und Gehäuseoberteil 16 vorgesehen sein.

An den beiden entgegengesetzt liegenden zugangsseitigen bzw. abgangsseitigen Schmalseitenwänden 32, 33, die senkrecht zur Verbindungslinie zweier zugehöriger Schlitze verlaufen, sind Einführöffnungen 34, 35, 36 und 36' bzw. Ausgangsöffnungen, in der der Darstellung nach Fig. 1 verdeckt und daher nicht sichtbar, vorgesehen, durch die Zugangsleiter ins Innere des Gehäuses 17 eingeführt bzw. Abgangsleiter aus dem Gehäuse 17 herausgeführt werden können. Unterhalb des Abschnittes 26 bzw. 27 befinden sich Anschlussklemmen zur Verbindung mit den entsprechenden Kontaktstücken.

An den Abgangsleitern werden Verbrauchernetze angeschlossen.

In der Ausführungsform nach Figur 1 sind an der zugangsseitigen Schmalseite 32 vier Zugangsöffnungen 34, 35, 36, 36' vorhanden. In der Zugangsöffnung 35 ist ein Phasenleiter 37 eingeführt. In die Zugangsöffnung 36' ist ein Neutralleiter 37' eingeführt. Es handelt sich um eine Ausführungsform für einen einphasigen Zählerplatz. Die Zugangsöffnungen 34 und 36 sind nicht von Zugangsleitern belegt. Sie sind mit jeweils einem Zugangs-Abdeckteil 39, 39' bedeckt. Die Zugangs-Abdeckteile 39, 39' sind hier als Abdeckplatten ausgeführt, die auf die Zugangsöffnungen 34, 36 aufgesetzt und darin verrastet werden. In einer weiteren denkbaren Ausführungsform könnten die Zugangs-Abdeckteile 39, 39' auch an dem Gehäuseoberteil 16 angeformt sein, beispielsweise in Art einer Abdeckzunge.

An der abgangsseitigen Schmalseite 33 sind in der Ausführungsform nach Fig. 1 drei Ausgangsöffnungen vorhanden, die allerdings aufgrund der perspektivischen Darstellung verdeckt und daher nicht sichtbar sind. In einer der Ausgangsöffnungen befindet sich ein abgehender Phasenleiter 38, die beiden anderen Ausgangsöffnungen sind nicht belegt. Die nicht belegten Ausgangsöffnungen sind von Abgangs-Abdeckplatten bedeckt, in derselben Weise, wie die nicht belegten Zugangsöffnungen von Zugangs-Abdeckteilen bedeckt sind.

In der Ausführungsform nach Figur 1 ist ein Zählertraggehäuse für eine einphasige Anwendung dargestellt. Es sind nur diejenigen Kontaktstücke, die mit Kontaktfahnen am Zähler in elektrisch leitende Verbindung gelangen können, vorhanden, die den Zugangsöffnungen 35 und 37' sowie der Ausgangsöffnung, in der sich der abgehende Phasenleiter 38 befindet, zugeordnet sind.

Die vorliegende Erfindung umfasst neben den beschriebenen Ausführungsbeispielen auch beliebige Kombinationen bevorzugter Ausführungsformen sowie einzelner Ausgestaltungsmerkmale oder Weiterbildungen, sofern diese sich nicht gegenseitig ausschließen.

### Bezugszeichenliste

15 Gehäuseunterteil
16 Gehäuseoberteil
17 Zählertraggehäuse
18 Schlitzbereich, mittlerer Gehäusebereich
19 Schlitz
20 Schlitz
21 Schlitz
22 Schlitz
23 Schlitz
24 Schlitz
25 Stufe
26 Stufe
27 abgangsseitiger Anschlussklemmenabschnitt
28 zugangsseitiger Anschlussklemmenabschnitt
29 Stufung
30 Stufung
31 Rastarm
32 zugangsseitige Schmalseitenwand
33 abgangsseitige Schmalseitenwand
34 Einführöffnung
35 Einführöffnung
36 Einführöffnung
36' Einführöffnung
37 Phasenleiter L2
37' Neutralleiter N
38 Phasenleiter L2
39 Zugangs-Abdeckteil
39' Zugangs-Abdeckteil

## Patentansprüche

1. Zählertraggehäuse (17) für einen Zählerschrank zur Montage eines Zählers, mit wenigstens drei Einführöffnungen (34, 35, 36, 36') für die Aufnahme von Anschlussleitern (37, 37'), und mit wenigstens drei Ausgangsöffnungen für die Aufnahme von Abgangsleitern (38),
**dadurch gekennzeichnet, dass** diejenigen Einführöffnungen (34, 36), die nicht zur Aufnahme eines Anschlussleiters vorgesehen sind, mit einem Einführ-Abdeckteil (39, 39') versehen sind, und dass diejenigen Ausgangsöffnungen, die nicht zur Aufnahme eines Abgangsleiters vorgesehen sind, mit einem Abgangs-Abdeckteil versehen sind.

2. Zählertraggehäuse (17) nach Anspruch 1, wobei das Zählertraggehäuse (17) ein Gehäuseunterteil (15) und ein daran befestigbares Gehäuseoberteil (16) umfasst, und wobei in dem Gehäuseoberteil (16) Schlitze (19, 20, 21, 22, 23, 24) zur Aufnahme von Kontaktfahnen eines auf das Zählertraggehäuse aufsetzbaren Stromzählers vorhanden sind, wobei die wenigstens drei Einführöffnungen (34, 35, 36, 36') in einer Einführ-Schmalseite (32) des Zählertraggehäuses (17) vorgesehen sind, wobei die wenigstens drei Ausgangsöffnungen in einer Abgangs-Schmalseite (33) des Zählertraggehäuses (17) vorgesehen sind, **dadurch gekennzeichnet, dass** das Gehäuseoberteil (16) mit dem Einführ-Abdeckteil (39, 39') und mit dem Abgangs-Abdeckteil versehen ist.

3. Zählertraggehäuse (17) nach Anspruch 2, **dadurch gekennzeichnet, dass** das Einführ-Abdeckteil (39, 39') und das Abgangs-Abdeckteil an dem Gehäuseoberteil (16) angeformt sind.

4. Zählertraggehäuse (17) nach Anspruch 2, wobei das Einführ-Abdeckteil (39, 39') und das Abgangs-Abdeckteil an dem Gehäuseoberteil (16) befestigt sind.

5. Zählertraggehäuse (17) nach Anspruch 4, wobei das Einführ-Abdeckteil (39, 39') und das Abgangs-Abdeckteil separate Deckel sind, die an dem Gehäuseoberteil (16) angebracht sind.

6. Zählertraggehäuse (17) nach Anspruch 5, wobei das Einführ-Abdeckteil (39, 39') und das Abgangs-Abdeckteil an dem Gehäuseoberteil (16) angerastet sind.

7. Zählertraggehäuse (17) nach einem der Ansprüche 2 bis 6, **dadurch gekennzeichnet, dass** anstelle des Gehäuseoberteils (16) das Gehäuseunterteil (15) mit dem Einführ-Abdeckteil und mit dem Abgangs-Abdeckteil versehen ist.

8. Zählertraggehäuse (17) nach Anspruch 1, wobei Einführöffnungen (34, 35, 36, 36') für die Aufnahme von drei Phasenleitern und eines Neutralleiters vorhanden sind, und wobei zwei der je einem Phasenleiter zugeordneten Einführöffnungen (34, 36) mit einem Einführ-Abdeckteil (39, 39') versehen sind, so dass zugangsseitig nur ein Phasenleiter (37) und der Neutralleiter (37') angeschlossen werden können.

9. Zählertraggehäuse (17) nach Anspruch 8, wobei Ausgangsöffnungen für die Aufnahme von drei Phasenleitern vorhanden sind, und wobei zwei der je einem Phasenleiter zugeordneten Ausgangsöffnungen mit einem Abgangs-Abdeckteil versehen sind, so dass abgangsseitig nur ein Phasenleiter (38) angeschlossen werden kann.

10. Zählertraggehäuse (17) nach Anspruch 1, **dadurch gekennzeichnet, dass** nur denjenigen Ein- und Ausgangsöffnungen die zur Aufnahme eines Anschluss- bzw. Abgangsleiters vorgesehen sind, entsprechende Kontaktstücke im Inneren des Zählertraggehäuses zugeordnet sind.
